# EUROPEAN PATENT SPECIFICATION

(11) **EP 3 288 079 B1**
(45) Date of publication and mention of the grant of the patent: **08.07.2020**
(21) Application number: 15839121.9
(22) Date of filing: 20.08.2015
(51) Int. Cl.: H01L 27/02, G02F 1/1362

(54) **ARRAY SUBSTRATE AND PREPARATION METHOD THEREFOR, DISPLAY PANEL, AND DISPLAY DEVICE**
ARRAYSUBSTRAT UND HERSTELLUNGSVERFAHREN DAFÜR, ANZEIGETAFEL UND ANZEIGEVORRICHTUNG
SUBSTRAT DE MATRICE ET PROCÉDÉ DE PRÉPARATION CORRESPONDANT, ÉCRAN D'AFFICHAGE ET DISPOSITIF D'AFFICHAGE

(30) Priority: 22.04.2015 CN 201510195300
(43) Date of publication of application: 28.02.2018
(73) Proprietor: BOE Technology Group Co., Ltd., Beijing 100015 (CN); Hefei Xinsheng Optoelectronics Technology Co., Ltd, Anhui 230012 (CN)
(72) Inventor: ZOU, Zhixiang, Beijing 100176 (CN); HUANG, Yinhu, Beijing 100176 (CN); YANG, Chengshao, Beijing 100176 (CN); SONG, Botao, Beijing 100176 (CN)
(74) Representative: Cohausz & Florack
(86) International application number: PCT/CN2015/087592
(87) International publication number: WO 2016/169169

(56) References cited:
- CN-A- 101 241 911
- CN-A- 101 697 053
- CN-U- 203 324 619
- US-A1- 2011 297 930
- US-A1- 2014 139 770

## Description

### FIELD OF THE INVENTION

The present invention relates to the field of display design, and particularly relates to an array substrate and a manufacturing method thereof, a display panel and a display device.

### BACKGROUND OF THE INVENTION

In the design of peripheral wirings of an array substrate, peripheral gate lines and peripheral data lines are required to be alternatively arranged in a peripheral wiring area, in order to solve the problem of insufficient space. In the prior art, an outer surface (i.e., the surface far from a substrate) of a protection layer in the peripheral wiring area is flat, because thickness (200 nm to 400 nm) of the protection layer corresponding to positions where the peripheral data lines are located is smaller than a sum of thicknesses (a total of 600 nm to 800 nm) of an insulation layer and the protection layer corresponding to positions where the peripheral gate lines are located (i.e., compared with the peripheral data lines which are only protected by the protection layer, in addition to the protection of the protection layer, the peripheral gate lines are also protected by the insulation layer), compared with the peripheral gate lines, the peripheral data lines are more fragile and likely to be scratched or crushed by a foreign material, which leads to a problem of line defect, thereby influencing the stability of product performance.

US patent application US 2014/139770 A1 discloses a liquid crystal device including an array substrate facing an opposite substrate; and a liquid crystal layer between the array and opposite substrate, the array substrate including a gate electrode and gate line on a base substrate; a gate insulating layer covering the gate electrode and including a trench crossing the gate line; a semiconductor layer on the gate insulating layer and including a channel area overlapping the gate electrode, a source area at one side of the channel area, and a drain area at another side of the channel area; a pixel electrode on the gate insulating layer and spaced apart from the semiconductor layer; a source electrode connected to the source area; a drain electrode connected to the drain area and the pixel electrode; a data line connected to the source electrode and being inside the trench; and a common electrode insulated from the pixel electrode.

### SUMMARY OF THE INVENTION

In view of the aforementioned problems, embodiments of the present invention provide an array substrate and a manufacturing method thereof, a display panel and a display device, which can reduce probability of crushing or scratching peripheral data lines by a foreign material, thereby improving the stability of the product performance.

According to embodiments of the present invention, an array substrate is provided, including: a base substrate, and a peripheral gate line, a gate insulation layer, a peripheral data line and a protection layer which are formed on the base substrate in turn, wherein a surface height of the protection layer corresponding to a position where the peripheral gate line is located is higher than that of the protection layer corresponding to a position where the peripheral data line is located.

Preferably, a groove is arranged at one part of the gate insulation layer corresponding to the peripheral data line, and the peripheral data line is formed in the groove, so as to enable at least one part of the peripheral data line in the height direction to fall into the groove.

Preferably, a depth of the groove in a direction perpendicular to the base substrate is 100 to 400 nm.

Preferably, the array substrate further includes a semiconductor layer which is located between the gate insulation layer and the protection layer, and overlapped with the peripheral gate line along the direction perpendicular to the base substrate.

Preferably, a thickness of the semiconductor layer in the direction perpendicular to the base substrate is 100 to 300 nm.

According to embodiments of the present invention, a display panel is further provided, including any one of the above array substrates.

According to embodiments of the present invention, a display device is further provided, including the above display panel.

According to embodiments of the present invention, a manufacturing method of an array substrate is further provided, including a step of:
forming a pattern of a peripheral gate line, a gate insulation layer, a pattern of a peripheral data line and a protection layer on the base substrate in turn, wherein a surface height of the protection layer corresponding to a position where the pattern of the peripheral gate line is located is higher than that of the protection layer corresponding to a position where the pattern of the peripheral data line is located.

Preferably, the manufacturing method specifically includes steps of:
forming a gate metal layer on the base substrate, and forming the pattern of the peripheral gate line;
forming a pattern of the gate insulation layer on the base substrate formed with the pattern of the peripheral gate line, the pattern of the gate insulation layer including a groove formed in a design area of the pattern of the peripheral data line;
forming a source-drain metal layer on the pattern of the gate insulation layer, and forming the pattern of the peripheral data line in the groove included in the pattern of the gate insulation layer, so as to enable at least one part of the pattern of the peripheral data line in the height direction to fall into the groove; and
forming the protection layer on the base substrate formed with the pattern of the peripheral data line and the pattern of the gate insulation layer.

Preferably, a depth of the groove in a direction perpendicular to the base substrate is 100 to 400 nm.

Preferably, the manufacturing method specifically includes steps of:
forming a gate metal layer on the base substrate, and forming the pattern of the peripheral gate line;
forming the gate insulation layer on the base substrate formed with the pattern of the peripheral gate line;
forming a pattern of the semiconductor layer on the gate insulation layer, wherein the pattern of the semiconductor layer is arranged at one part which is overlapped with the pattern of the peripheral gate line along a direction perpendicular to the base substrate;
forming a source-drain metal layer on the gate insulation layer, and forming the pattern of the peripheral data line; and
forming the protection layer on the base substrate formed with the pattern of the peripheral data line, the gate insulation layer and the pattern of the semiconductor layer.

Preferably, a thickness of the semiconductor layer in the direction perpendicular to the base substrate is 100 to 300 nm.

Preferably, the manufacturing method specifically includes steps of:
forming a gate metal layer on the base substrate, and forming the pattern of the peripheral gate line;
forming a pattern of the gate insulation layer on the base substrate formed with the pattern of the peripheral gate line, the pattern of the gate insulation layer including a groove formed in a design area of the pattern of the peripheral data line;
forming a pattern of a semiconductor layer on the pattern of the gate insulation layer, wherein the pattern of the semiconductor layer is arranged at one part which is overlapped with the pattern of the peripheral gate line along a direction perpendicular to the base substrate;
forming a source-drain metal layer on the pattern of the gate insulation layer, and forming the pattern of the peripheral data line in the groove included in the pattern of the gate insulation layer, so as to enable at least one part of the pattern of the peripheral data line in the height direction to fall into the groove; and
forming the protection layer on the base substrate formed with the pattern of the peripheral data line, the pattern of the gate insulation layer and the pattern of the semiconductor layer.

Preferably, a thickness of the semiconductor layer in the direction perpendicular to the base substrate is 100 to 300 nm.

Preferably, a depth of the groove in the direction perpendicular to the base substrate is 100 to 400 nm.

In the array substrate and the manufacturing method thereof, the display panel and the display device provided according to embodiments of the present invention, because the surface height of the protection layer corresponding to the position where the peripheral gate line is located is higher than that of the protection layer corresponding to the position where the peripheral data line is located, when in contact with the peripheral wiring area of the array substrate, a foreign material is first in contact with the protection layer corresponding to the position where the peripheral gate line is located, thereby reducing probability of contact between the foreign material and the protection layer corresponding to the position where the peripheral data line is located, to reduce probability of crushing or scratching the peripheral data line by the foreign material, and improve the stability of the product performance.

### BRIEF DESCRIPTION OF THE DRAWINGS

Fig. 1 is a structural diagram of an array substrate provided by embodiments of the present invention;
Fig. 2 is another structural diagram of an array substrate provided by embodiments of the present invention; and
Fig. 3 is still another structural diagram of an array substrate provided by embodiments of the present invention.

### DESCRIPTION OF THE PREFERRED EMBODIMENT

The technical solutions in embodiments of the present invention will be described clearly and completely as below with reference to the accompanying drawings in embodiments of the present invention, obviously, the described embodiments are not all the embodiments, but only part of embodiments of the present invention. According to the embodiments of the present invention, all other embodiments obtained by those skilled in the art without creative effort fall into the protection scope of the present invention.

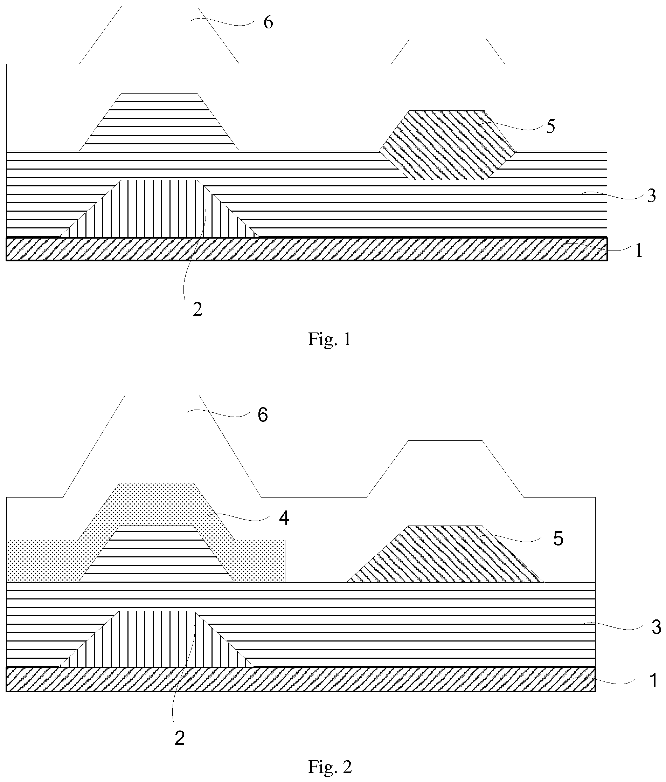

According to embodiments of the present invention, an array substrate, a display panel including the array substrate, and a display device including the display panel are provided. As shown in Fig. 1 to Fig.3, the array substrate includes a base substrate 1, and a peripheral gate line 2, a gate insulation layer 3, a peripheral data line 5 and a protection layer 6 which are formed on the base substrate 1 in turn, wherein a surface height of the protection layer 6 corresponding to a position where the peripheral gate line 2 is located is higher than that of the protection layer 6 corresponding to a position where the peripheral data line 5 is located. Because the surface height of the protection layer 6 corresponding to the position where the peripheral gate line 2 is located is higher than that of the protection layer 6 corresponding to the position where the peripheral data line 5 is located, when in contact with the peripheral wiring area of the array substrate, a foreign material is first in contact with the protection layer 6 corresponding to the position where the peripheral gate line 2 is located, thereby reducing probability of contact between the foreign material and the protection layer 6 corresponding to the position where the peripheral data line 5 is located, to reduce probability of crushing or scratching the peripheral data line 5 by the foreign material, and improve the stability of the product performance. Furthermore, the stabilities of the product performances of the display panel including the array substrate and the display device including the display panel are improved.

According to embodiments of the present invention, a manufacturing method of an array substrate is further provided, including a step of: forming a pattern of a peripheral gate line, a gate insulation layer, a pattern of a peripheral data line and a protection layer on a base substrate in turn, wherein, a surface height of the protection layer corresponding to a position where the pattern of the peripheral gate line is located is higher than that of the protection layer corresponding to a position where the pattern of the peripheral data line is located.

Specifically, the array substrate, through the following specific structures, may achieve that the surface height of the protection layer corresponding to the position where the pattern of the peripheral gate line is located is higher than that of the protection layer corresponding to the position where the pattern of the peripheral data line is located.

First mode: as shown in Fig. 1, the array substrate provided by the embodiments of the present invention includes a base substrate 1, and a peripheral gate line 2, a gate insulation layer 3, a peripheral data line 5 and a protection layer 6 which are formed on the base substrate 1 in turn. Wherein, a groove is arranged at one part of the gate insulation layer 3 corresponding to the peripheral data line 5, and the peripheral data line 5 is formed in the groove, so as to enable at least one part of the peripheral data line 5 in the height direction to fall into the groove.

In the array substrate, because at least one part of the peripheral data line 5 in the height direction is fallen into the groove, compared with the prior art, during formation of the protection layer 6, the surface height of the protection layer 6 corresponding to the position where the peripheral data line 5 is located may be reduced, and yet the surface height of the protection layer 6 corresponding to the position where the peripheral gate line 2 is located is not changed, thereby enabling the surface height of the protection layer 6 corresponding to the position where the peripheral gate line 2 is located to be higher than that of the protection layer 6 corresponding to the position where the peripheral data line 5 is located.

Preferably, a depth of the groove in the direction perpendicular to the base substrate 1 is 100 to 400 nm, such as 100 nm, 150 nm, 200 nm, 250 nm, 300 nm, 350 nm, and 400 nm.

Correspondingly, the array substrate provided in the first mode may be manufactured by following manufacturing method, which specifically includes steps of:
forming a gate metal layer on the base substrate 1 through a single patterning process, and forming a pattern of the peripheral gate line 2;
forming a pattern of the gate insulation layer 3 on the base substrate 1 formed with the pattern of the peripheral gate line 2 through a halftone mask process, wherein the pattern of the gate insulation layer 3 includes a groove formed in a design area of the pattern of the peripheral data line 5;
forming a source-drain metal layer on the pattern of the gate insulation layer 3 through a single patterning process, and forming the pattern of the peripheral data line 5 in the groove included in the pattern of the gate insulation layer 3, so as to enable at least one part of the pattern of the peripheral data line 5 in the height direction to fall into the groove; and
forming the protection layer 6 on the base substrate 1 formed with the pattern of the peripheral data line 5 and the pattern of the gate insulation layer 3.

Second mode: as shown in Fig. 2, the array substrate provided by the embodiments of the present invention includes a substrate 1, and a peripheral gate line 2, a gate insulation layer 3, a semiconductor layer 4, a peripheral data line 5 and a protection layer 6 which are formed on the base substrate 1 in turn. Wherein, the semiconductor layer 4 is located between the gate insulation layer 3 and the protection layer 6, and overlapped with the peripheral gate line 2 along the direction perpendicular to the base substrate 1.

Because the semiconductor layer 4, located between the gate insulation layer 3 and the protection layer 6, is overlapped with the peripheral gate line 2 along the direction perpendicular to the base substrate 1, compared with the prior art, the surface height of the protection layer 6 corresponding to the position where the peripheral gate line 2 is located may be increased, and yet the surface height of the protection layer 6 corresponding to the position where the peripheral data line 5 is located is not changed, thereby enabling the surface height of the protection layer 6 corresponding to the position where the peripheral gate line 2 is located to be higher than that of the protection layer 6 corresponding to the position where the peripheral data line 5 is located.

Preferably, a thickness of the semiconductor layer 4 in the direction perpendicular to the base substrate 1 is 100 to 300 nm, such as 100 nm, 130 nm, 150 nm, 200 nm, 230 nm, 250 nm, and 300 nm.

Correspondingly, the array substrate provided in the second mode may be manufactured by the following manufacturing method, and the manufacturing method specifically includes steps of:
forming a gate metal layer on the base substrate 1 through a single patterning process, and forming a pattern of the peripheral gate line 2;
forming a gate insulation layer 3 on the base substrate 1 formed with the pattern of the peripheral gate line 2;
forming a pattern of the semiconductor layer 4 on the gate insulation layer 3, wherein the pattern of the semiconductor layer 4 is arranged at one part which is overlapped with the peripheral gate line 2 along the direction perpendicular to the base substrate 1;
forming a source-drain metal layer on the gate insulation layer 3, and forming a pattern of the peripheral data line 5; and
forming the protection layer 6 on the base substrate 1 formed with the pattern of the peripheral data line 5, the gate insulation layer 3 and the pattern of the semiconductor layer 4.

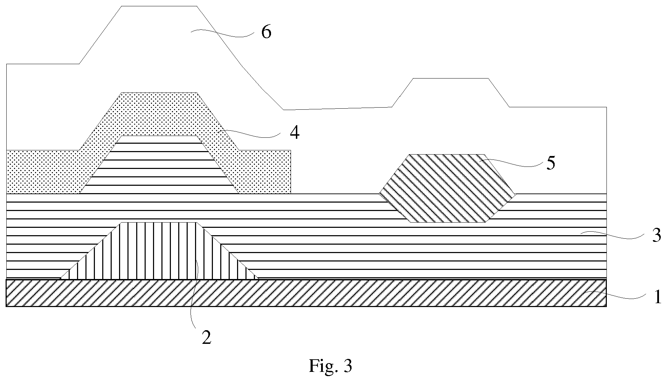

Third mode: As shown in Fig. 3, the array substrate provided by the embodiments of the present invention includes a base substrate 1, and a peripheral gate line 2, a gate insulation layer 3, a semiconductor layer 4, a peripheral data line 5 and a protection layer 6 which are formed on the base substrate 1 in turn. Wherein, a groove is arranged at one part of the gate insulation layer 3 corresponding to the peripheral data line 5, and the peripheral data line 5 is formed in the groove, so as to enable at least one part of the peripheral data line 5 in the height direction to fall into the groove; the semiconductor layer 4 is located between the gate insulation layer 3 and the protection layer 6, and overlapped with the peripheral gate line 2 along the direction perpendicular to the base substrate 1.

In the array substrate, because at least one part of the peripheral data line 5 in the height direction is fallen into the groove, compared with the prior art, during formation of the protection layer 6, the surface height of the protection layer 6 corresponding to the position where the peripheral data line 5 is located may be reduced; meanwhile, because the semiconductor layer 4, located between the gate insulation layer 3 and the protection layer 6, is overlapped with the peripheral gate line 2 along the direction perpendicular to the base substrate 1, compared with the prior art, the surface height of the protection layer 6 corresponding to the position where the peripheral gate line 2 is located may be increased. Hence, the surface height of the protection layer 6 corresponding to the position where the peripheral gate line 2 is located is higher than that of the protection layer 6 corresponding to the position where the peripheral data line 5 is located.

Preferably, the depth of the groove in the direction perpendicular to the base substrate is 100 to 400 nm, such as 100 nm, 150 nm, 200 nm, 250 nm, 300 nm, 350 nm, and 400 nm.

Preferably, a thickness of the semiconductor layer 4 in the direction perpendicular to the base substrate 1 is 100 to 300 nm, such as 100 nm, 130 nm, 150 nm, 200 nm, 230 nm, 250 nm, and 300 nm.

Correspondingly, the array substrate provided in the third mode may be manufactured by following manufacturing method, and the manufacturing method specifically includes steps of:
forming a gate metal layer on the base substrate 1 through a single patterning process, and forming a pattern of the peripheral gate line 2;
forming a pattern of the gate insulation layer 3 on the base substrate 1 formed with the pattern of the peripheral gate line 2, wherein the pattern of the gate insulation layer 3 includes a groove formed in a design area of the pattern of the peripheral data line 5;
forming a pattern of the semiconductor layer 4 on the pattern of the gate insulation layer 3, wherein the pattern of the semiconductor layer 4 is arranged at one part which is overlapped with the peripheral gate line 2 along the direction perpendicular to the base substrate 1;
forming a source-drain metal layer on the pattern of the gate insulation layer 3 through a single patterning process, and forming a pattern of the peripheral data line 5 in the groove included in the pattern of the gate insulation layer 3, so as to enable at least one part of the pattern of the peripheral data line 5 in the height direction to fall into the groove; and
forming the protection layer 6 on the base substrate 1 formed with the pattern of the peripheral data line 5, the pattern of the gate insulation layer 3 and the pattern of the semiconductor layer 4.

Certainly, the above array substrates may be embodied through other structures, as long as the surface height of the protection layer corresponding to the position where the peripheral gate line is located is higher than that of the protection layer corresponding to the position where the peripheral data line is located, probability of crushing or scratching the peripheral data line by the foreign material may be reduced, thereby improving the stability of the product performance.

Apparently, a person of ordinary skill in the art may make various improvements and variations on the embodiments of the present invention without departing from the scope of the present invention as defined in the appended claims.

## Claims

1. An array substrate, comprising a peripheral wiring area,
in the peripheral wiring area, the array substrate comprising:
a base substrate (1);
a peripheral gate line (2) on the base substrate (1);
a gate insulation layer (3) on a side of the peripheral gate line (2) away from the base substrate (1);
a peripheral data line (5) on a side of the gate insulation layer (3) away from the base substrate (1); and
a protection layer (6) on a side of the gate insulation layer (3) away from the base substrate (1) and covering the peripheral data line (5),
**characterized in that**, a surface height of the protection layer (6) corresponding to a position where the peripheral gate line (2) is located is higher than a surface height of the protection layer (6) corresponding to a position where the peripheral data line (5) is located.

2. The array substrate according to claim 1, wherein a groove is arranged at one part of the gate insulation layer (3) corresponding to the peripheral data line (5), and the peripheral data line (5) is formed in the groove, so as to enable at least one part of the peripheral data line (5) in the height direction to fall into the groove.

3. The array substrate according to claim 2, wherein a depth of the groove in a direction perpendicular to the base substrate (1) is 100 to 400 nm.

4. The array substrate according to claim 1 or 2, wherein the array substrate in the peripheral wiring area further comprises a semiconductor layer (4) which is located between the gate insulation layer (3) and the protection layer (6), and overlapped with the peripheral gate line (2) along a direction perpendicular to the base substrate (1).

5. The array substrate according to claim 4, wherein a thickness of the semiconductor layer (4) in the direction perpendicular to the base substrate (1) is 100 to 300 nm.

6. A display panel, comprising the array substrate according to any one of claims 1 to 5.

7. A display device, comprising the display panel according to claim 6.

8. A manufacturing method of an array substrate having a peripheral wiring area, in the peripheral wiring area, the array substrate comprising a base substrate (1), a peripheral gate line (2), a gate insulation layer (3), a peripheral data line (5) and a protection layer (6), the method comprising a step of:
forming a pattern of the peripheral gate line (2), the gate insulation layer (3), a pattern of the peripheral data line (5) and the protection layer (6) on the base substrate (1) in turn;
the pattern of the peripheral gate line (2) being formed on the base substrate (1);
the gate insulation layer (3) being formed on a side of the pattern of the peripheral gate line (2) away from the base substrate (1);
the pattern of the peripheral data line (5) being formed on a side of the gate insulation layer (3) away from the base substrate (1); and
the protection layer (6) being formed on a side of the gate insulation layer (3) away from the base substrate (1) and covering the pattern of the peripheral data line (5),
**characterized in that**, a surface height of the protection layer (6) corresponding to a position where the pattern of the peripheral gate line (2) is located is formed to be higher than a surface height of the protection layer (6) corresponding to a position where the pattern of the peripheral data line (5) is located.

9. The manufacturing method according to claim 8, wherein the step of forming the pattern of the peripheral gate line (2), the gate insulation layer (3), the pattern of the peripheral data line (5) and the protection layer (6) on the base substrate (1) in turn comprises steps of:
forming a gate metal layer on the base substrate (1), and forming the pattern of the peripheral gate line (2);
forming a pattern of the gate insulation layer (3) on the base substrate (1) formed with the pattern of the peripheral gate line (2), the pattern of the gate insulation layer (3) comprising a groove formed in a design area of the pattern of the peripheral data line (5);
forming a source-drain metal layer on the pattern of the gate insulation layer (3), and forming the pattern of the peripheral data line (5) in the groove included in the pattern of the gate insulation layer (3), so as to enable at least one part of the pattern of the peripheral data line (5) in the height direction to fall into the groove; and
forming the protection layer (6) on the base substrate (1) formed with the pattern of the peripheral data line (5) and the pattern of the gate insulation layer (3).

10. The manufacturing method according to claim 9, wherein a depth of the groove in a direction perpendicular to the base substrate (1) is 100 to 400 nm.

11. The manufacturing method according to claim 8, wherein the step of forming the pattern of the peripheral gate line (2), the gate insulation layer (3), the pattern of the peripheral data line (5) and the protection layer (6) on the base substrate (1) in turn comprises steps of:
forming a gate metal layer on the base substrate (1), and forming the pattern of the peripheral gate line (2);
forming the gate insulation layer (3) on the base substrate (1) formed with the pattern of the peripheral gate line (2);
forming a pattern of a semiconductor layer (4) on the gate insulation layer (3), wherein the pattern of the semiconductor layer (4) is arranged at one part which is overlapped with the
pattern of the peripheral gate line (2) along a direction perpendicular to the base substrate (1);
forming a source-drain metal layer on the gate insulation layer (3), and forming the pattern of the peripheral data line (5); and
forming the protection layer (6) on the base substrate (1) formed with the pattern of the peripheral data line (5), the gate insulation layer (3) and the pattern of the semiconductor layer (4).

12. The manufacturing method according to claim 11, wherein a thickness of the semiconductor layer (4) in the direction perpendicular to the base substrate (1) is 100 to 300 nm.

13. The manufacturing method according to claim 8, wherein the step of forming the pattern of the peripheral gate line (2), the gate insulation layer (3), the pattern of the peripheral data line (5) and the protection layer (6) on the base substrate (1) in turn comprises steps of:
forming a gate metal layer on the base substrate (1), and forming the pattern of the peripheral gate line (2);
forming a pattern of the gate insulation layer (3) on the base substrate (1) formed with the pattern of the peripheral gate line (2), the pattern of the gate insulation layer (3) comprising a groove formed in a design area of the pattern of the peripheral data line (5);
forming a pattern of a semiconductor layer (4) on the pattern of the gate insulation layer (3), wherein the pattern of the semiconductor layer (4) is arranged at one part which is overlapped with the pattern of peripheral gate line (2) along a direction perpendicular to the base substrate (1);
forming a source-drain metal layer on the pattern of the gate insulation layer (3), and forming the pattern of the peripheral data line (5) in the groove included in the pattern of the gate insulation layer (3), so as to enable at least one part of the pattern of the peripheral data line (5) in the height direction to fall into the groove; and
forming the protection layer (6) on the base substrate (1) formed with the pattern of the peripheral data line (5), the pattern of the gate insulation layer (3) and the pattern of the semiconductor layer (4).

14. The manufacturing method according to claim 13, wherein a thickness of the semiconductor layer (4) in the direction perpendicular to the base substrate (1) is 100 to 300 nm.

15. The manufacturing method according to claim 13 or 14, wherein a depth of the groove in the direction perpendicular to the base substrate (1) is 100 to 400 nm.

## Patentansprüche

1. Arraysubstrat, das einen peripheren Verdrahtungsbereich aufweist,
wobei das Arraysubstrat in dem peripheren Verdrahtungsbereich aufweist:
ein Basissubstrat (1);
eine periphere Gate-Leitung (2) auf dem Basissubstrat (1);
eine Gate-Isolierschicht (3) auf einer von dem Basissubstrat (1) abgewandten Seite der peripheren Gate-Leitung (2);
eine periphere Datenleitung (5) auf einer von dem Basissubstrat (1) abgewandten Seite der Gate-Isolierschicht (3); und
eine Schutzschicht (6), die auf einer von dem Basissubstrat (1) abgewandten Seite der Gate-Isolierschicht (3) angeordnet ist und die periphere Datenleitung (5) bedeckt,
**dadurch gekennzeichnet, dass** eine Oberflächenhöhe der Schutzschicht (6), die einer Position entspricht, an der die periphere Gate-Leitung (2) angeordnet ist, höher ist als eine Oberflächenhöhe der Schutzschicht (6), die einer Position entspricht, an der die periphere Datenleitung (5) angeordnet ist.

2. Arraysubstrat nach Anspruch 1, wobei an einem Teil der Gate-Isolierschicht (3), der der peripheren Datenleitung (5) entspricht, eine Nut angeordnet ist und die periphere Datenleitung (5) in der Nut so gebildet ist, dass mindestens ein Teil der peripheren Datenleitung (5) in der Höhenrichtung in die Nut fallen kann.

3. Arraysubstrat nach Anspruch 2, wobei eine Tiefe der Nut in einer Richtung senkrecht zu dem Basissubstrat (1) 100 bis 400 nm beträgt.

4. Arraysubstrat nach Anspruch 1 oder 2, wobei das Arraysubstrat in dem peripheren Verdrahtungsbereich ferner eine Halbleiterschicht (4) aufweist, die zwischen der Gate-Isolierschicht (3) und der Schutzschicht (6) angeordnet ist und mit der peripheren Gate-Leitung (2) in einer Richtung senkrecht zu dem Basissubstrat (1) überlappt ist.

5. Arraysubstrat nach Anspruch 4, wobei eine Dicke der Halbleiterschicht (4) in der Richtung senkrecht zu dem Basissubstrat (1) 100 bis 300 nm beträgt.

6. Anzeigetafel, die das Arraysubstrat nach einem der Ansprüche 1 bis 5 aufweist.

7. Anzeigevorrichtung, die die Anzeigetafel nach Anspruch 6 aufweist.

8. Herstellungsverfahren für ein Arraysubstrat mit einem peripheren Verdrahtungsbereich in dem peripheren Verdrahtungsbereich, wobei das Arraysubstrat ein Basissubstrat (1), eine periphere Gate-Leitung (2), eine Gate-Isolierschicht (3), eine periphere Datenleitung (5) und eine Schutzschicht (6) aufweist, wobei das Verfahren den folgenden Schritt umfasst:
Bilden eines Musters der peripheren Gate-Leitung (2), der Gate-Isolierschicht (3), eines Musters der peripheren Datenleitung (5) und der Schutzschicht (6) der Reihe nach auf dem Basissubstrat (1);
wobei das Muster der peripheren Gate-Leitung (2) auf dem Basissubstrat (1) gebildet wird;
wobei die Gate-Isolierschicht (3) auf einer von dem Basissubstrat (1) abgewandten Seite des Musters der peripheren Gate-Leitung (2) gebildet wird;
wobei das Muster der peripheren Datenleitung (5) auf einer von dem Basissubstrat (1) abgewandten Seite der Gate-Isolierschicht (3) gebildet wird; und
wobei die Schutzschicht (6), die auf einer von dem Basissubstrat (1) abgewandten Seite der Gate-Isolierschicht (3) gebildet wird und das Muster der peripheren Datenleitung (5) bedeckt,
**dadurch gekennzeichnet, dass** eine Oberflächenhöhe der Schutzschicht (6), die einer Position entspricht, an der das Muster der peripheren Gate-Leitung (2) angeordnet ist, so gebildet ist, dass sie höher ist als eine Oberflächenhöhe der Schutzschicht (6), die einer Position entspricht, an der das Muster der peripheren Datenleitung (5) angeordnet ist.

9. Herstellungsverfahren nach Anspruch 8, wobei der Schritt des Bildens des Musters der peripheren Gate-Leitung (2), der Gate-Isolierschicht (3), des Musters der peripheren Datenleitung (5) und der Schutzschicht (6) auf dem Basissubstrat (1) der Reihe nach die folgenden Schritte umfasst:
Bilden einer Gate-Metallschicht auf dem Basissubstrat (1), und Bilden des Musters der peripheren Gate-Leitung (2);
Bilden eines Musters der Gate-Isolierschicht (3) auf dem Basissubstrat (1), das mit dem Muster der peripheren Gate-Leitung (2) gebildet ist, wobei das Muster der Gate-Isolierschicht (3) eine Nut aufweist, die in einem Entwurfsbereich des Musters der peripheren Datenleitung (5) gebildet ist;
Bilden einer Source-Drain-Metallschicht auf dem Muster der Gate-Isolierschicht (3) und Bilden des Musters der peripheren Datenleitung (5) in der Nut, die in dem Muster der Gate-Isolierschicht (3) enthalten ist, so dass mindestens ein Teil des Musters der peripheren Datenleitung (5) in der Höhenrichtung in die Nut fallen kann; und
Bilden der Schutzschicht (6) auf dem Basissubstrat (1), die mit dem Muster der peripheren Datenleitung (5) und dem Muster der Gate-Isolierschicht (3) gebildet ist.

10. Herstellungsverfahren nach Anspruch 9, wobei eine Tiefe der Nut in einer Richtung senkrecht zu dem Basissubstrat (1) 100 bis 400 nm beträgt.

11. Herstellungsverfahren nach Anspruch 8, wobei der Schritt des Bildens des Musters der peripheren Gate-Leitung (2), der Gate-Isolierschicht (3), des Musters der peripheren Datenleitung (5) und der Schutzschicht (6) auf dem Basissubstrat (1) der Reihe nach die folgenden Schritte umfasst:
Bilden einer Gate-Metallschicht auf dem Basissubstrat (1), und Bilden des Musters der peripheren Gate-Leitung (2);
Bilden der Gate-Isolierschicht (3) auf dem Basissubstrat (1), die mit dem Muster der peripheren Gate-Leitung (2) gebildet ist;
Bilden eines Musters einer Halbleiterschicht (4) auf der Gate-Isolierschicht (3), wobei das Muster der Halbleiterschicht (4) an einem Teil angeordnet ist, der mit dem Muster der peripheren Gate-Leitung (2) entlang einer Richtung senkrecht zu dem Basissubstrat (1) überlappt ist;
Bilden einer Source-Drain-Metallschicht auf der Gate-Isolierschicht (3) und Bilden des Musters der peripheren Datenleitung (5); und
Bilden der Schutzschicht (6) auf dem Basissubstrat (1), die mit dem Muster der peripheren Datenleitung (5), der Gate-Isolierschicht (3) und dem Muster der Halbleiterschicht (4) gebildet ist.

12. Herstellungsverfahren nach Anspruch 11, wobei eine Dicke der Halbleiterschicht (4) in der Richtung senkrecht zu dem Basissubstrat (1) 100 bis 300 nm beträgt.

13. Herstellungsverfahren nach Anspruch 8, wobei der Schritt des Bildens des Musters der peripheren Gate-Leitung (2), der Gate-Isolierschicht (3), des Musters der peripheren Datenleitung (5) und der Schutzschicht (6) auf dem Basissubstrat (1) der Reihe nach die folgenden Schritte umfasst:
Bilden einer Gate-Metallschicht auf dem Basissubstrat (1), und Bilden des Musters der peripheren Gate-Leitung (2);
Bilden eines Musters der Gate-Isolierschicht (3) auf dem Basissubstrat (1), das mit dem Muster der peripheren Gate-Leitung (2) gebildet ist, wobei das Muster der Gate-Isolierschicht (3) eine Nut aufweist, die in einem Entwurfsbereich des Musters der peripheren Datenleitung (5) gebildet ist;
Bilden eines Musters einer Halbleiterschicht (4) auf dem Muster der Gate-Isolierschicht (3), wobei das Muster der Halbleiterschicht (4) an einem Teil angeordnet ist, der mit dem Muster der peripheren Gate-Leitung (2) entlang einer Richtung senkrecht zu dem Basissubstrat (1) überlappt ist;
Bilden einer Source-Drain-Metallschicht auf dem Muster der Gate-Isolierschicht (3) und Bilden des Musters der peripheren Datenleitung (5) in der Nut, die in dem Muster der Gate-Isolierschicht (3) enthalten ist, um so dass mindestens ein Teil des Musters der peripheren Datenleitung (5) in der Höhenrichtung in die Nut fallen kann; und
Bilden der Schutzschicht (6) auf dem Basissubstrat (1), das mit dem Muster der peripheren Datenleitung (5), dem Muster der Gate-Isolierschicht (3) und dem Muster der Halbleiterschicht (4) gebildet ist.

14. Herstellungsverfahren nach Anspruch 13, wobei eine Dicke der Halbleiterschicht (4) in der Richtung senkrecht zu dem Basissubstrat (1) 100 bis 300 nm beträgt.

15. Herstellungsverfahren nach Anspruch 13 oder 14, wobei eine Tiefe der Nut in der Richtung senkrecht zu dem Basissubstrat (1) 100 bis 400 nm beträgt.

## Revendications

1. Substrat de matrice, comprenant une zone de câblage périphérique, dans la zone de câblage périphérique, le substrat de matrice comprenant :
un substrat de base (1) ;
une ligne de grille périphérique (2) sur le substrat de base (1) ;
une couche d'isolation de grille (3) sur un côté de la ligne de grille périphérique (2) distant du substrat de base (1) ;
une ligne de données périphérique (5) sur un côté de la couche d'isolation de grille (3) distant du substrat de base (1) ; et
une couche de protection (6) sur un côté de la couche d'isolation de grille (3) distant du substrat de base (1) et recouvrant la ligne de données périphérique (5),
**caractérisé en ce que**, une hauteur de surface de la couche de protection (6) correspondant à une position où la ligne de grille périphérique (2) est située est supérieure à une hauteur de surface de la couche de protection (6) correspondant à une position où la ligne de données périphérique (5) est localisée.

2. Substrat de matrice selon la revendication 1, dans lequel une rainure est disposée sur une partie de la couche d'isolation de grille (3) correspondant à la ligne de données périphérique (5), et la ligne de données périphérique (5) est formée dans la rainure, de manière à permettre à au moins une partie de la ligne de données périphérique (5) dans le sens de la hauteur de tomber dans la rainure.

3. Substrat de matrice selon la revendication 2, dans lequel une profondeur de la rainure dans une direction perpendiculaire au substrat de base (1) est de 100 à 400 nm.

4. Substrat de matrice selon la revendication 1 ou 2, dans lequel le substrat de matrice dans la zone de câblage périphérique comprend en outre une couche semi-conductrice (4) qui est située entre la couche d'isolation de grille (3) et la couche de protection (6), et chevauchée par la ligne de grille périphérique (2) le long d'une direction perpendiculaire au substrat de base (1).

5. Substrat de matrice selon la revendication 4, dans lequel une épaisseur de la couche semi-conductrice (4) dans la direction perpendiculaire au substrat de base (1) est de 100 à 300 nm.

6. Panneau d'affichage, comprenant le substrat de matrice selon l'une quelconque des revendications 1 à 5.

7. Dispositif d'affichage, comprenant le panneau d'affichage selon la revendication 6.

8. Procédé de fabrication d'un substrat de matrice ayant une zone de câblage périphérique, dans la zone de câblage périphérique, le substrat de matrice comprenant un substrat de base (1), une ligne de grille périphérique (2), une couche d'isolation de grille (3), un une ligne de données périphérique (5) et une couche de protection (6), le procédé comprenant une étape consistant à :
former à tour de rôle un motif de la ligne de grille périphérique (2), la couche d'isolation de grille (3), un motif de la ligne de données périphérique (5) et la couche de protection (6) sur le substrat de base (1) ;
le motif de la ligne de grille périphérique (2) étant formé sur le substrat de base (1) ;
la couche d'isolation de grille (3) étant formée sur un côté du motif de la ligne de grille périphérique (2) distant du substrat de base (1) ;
le motif de la ligne de données périphérique (5) étant formé sur un côté de la couche d'isolation de grille (3) distant du substrat de base (1) ; et
la couche de protection (6) étant formée sur un côté de la couche d'isolation de grille (3) distant du substrat de base (1) et couvrant le motif de la ligne de données périphérique (5),
**caractérisé en ce que**, une hauteur de surface de la couche de protection (6) correspondant à une position où se trouve le motif de la ligne de grille périphérique (2) est formée pour être supérieure à une hauteur de surface de la couche de protection (6) correspondant à une position où se trouve le motif de la ligne de données périphérique (5).

9. Procédé de fabrication selon la revendication 8, dans lequel l'étape de formation du motif de la ligne de grille périphérique (2), de la couche d'isolation de grille (3), du motif de la ligne de données périphérique (5) et de la couche de protection (6) sur le substrat de base (1) comprend à son tour les étapes suivantes consistant à :
former une couche métallique de grille sur le substrat de base (1), et former le motif de la ligne de grille périphérique (2) ;
former un motif de la couche d'isolation de grille (3) sur le substrat de base (1) formé avec le motif de la ligne de grille périphérique (2), le motif de la couche d'isolation de grille (3) comprenant une rainure formée dans une zone de conception du motif de la ligne de données périphérique (5) ;
former une couche métallique source-drain sur le motif de la couche d'isolation de grille (3), et former le motif de la ligne de données périphérique (5) dans la rainure incluse dans le motif de la couche d'isolation de grille (3), de manière à permettre à au moins une partie du motif de la ligne de données périphérique (5) dans le sens de la hauteur de tomber dans la rainure ; et
former la couche de protection (6) sur le substrat de base (1) formé avec le motif de la ligne de données périphérique (5) et le motif de la couche d'isolation de grille (3).

10. Procédé de fabrication selon la revendication 9, dans lequel une profondeur de la rainure dans une direction perpendiculaire au substrat de base (1) est de 100 à 400 nm.

11. Procédé de fabrication selon la revendication 8, dans lequel l'étape de formation du motif de la ligne de grille périphérique (2), de la couche d'isolation de grille (3), du motif de la ligne de données périphérique (5) et de la couche de protection (6) sur le substrat de base (1) comprend à son tour les étapes suivantes consistant à :
former une couche métallique de grille sur le substrat de base (1), et former le motif de la ligne de grille périphérique (2) ;
former la couche d'isolation de grille (3) sur le substrat de base (1) formé avec le motif de la ligne de grille périphérique (2) ;
former un motif d'une couche semi-conductrice (4) sur la couche d'isolation de grille (3), dans lequel le motif de la couche semi-conductrice (4) est disposé au niveau d'une partie qui est chevauchée par le motif de la ligne de grille périphérique (2) le long d'une direction perpendiculaire au substrat de base (1) ;
former une couche métallique source-drain sur la couche d'isolation de grille (3), et former le motif de la ligne de données périphérique (5) ; et
former la couche de protection (6) sur le substrat de base (1) formé avec le motif de la ligne de données périphérique (5), la couche d'isolation de grille (3) et le motif de la couche semi-conductrice (4).

12. Procédé de fabrication selon la revendication 11, dans lequel une épaisseur de la couche semi-conductrice (4) dans la direction perpendiculaire au substrat de base (1) est de 100 à 300 nm.

13. Procédé de fabrication selon la revendication 8, dans lequel l'étape de formation du motif de la ligne de grille périphérique (2), de la couche d'isolation de grille (3), du motif de la ligne de données périphérique (5) et de la couche de protection (6) sur le substrat de base (1) comprend à son tour des étapes consistant à :
former une couche métallique de grille sur le substrat de base (1), et former le motif de la ligne de grille périphérique (2) ;
former un motif de la couche d'isolation de grille (3) sur le substrat de base (1) formé avec le motif de la ligne de grille périphérique (2), le motif de la couche d'isolation de grille (3) comprenant une rainure formée dans une zone de conception du motif de la ligne de données périphérique (5) ;
former un motif d'une couche semi-conductrice (4) sur le motif de la couche d'isolation de grille (3), dans lequel le motif de la couche semi-conductrice (4) est disposé au niveau d'une partie qui est chevauchée par le motif de la ligne de grille périphérique (2) le long d'une direction perpendiculaire au substrat de base (1) ;
former une couche métallique source-drain sur le motif de la couche d'isolation de grille (3), et former le motif de la ligne de données périphérique (5) dans la rainure incluse dans le motif de la couche d'isolation de grille (3), de manière à permettre à au moins une partie du motif de la ligne de données périphérique (5) dans le sens de la hauteur de tomber dans la rainure ; et
former la couche de protection (6) sur le substrat de base (1) formé avec le motif de la ligne de données périphérique (5), le motif de la couche d'isolation de grille (3) et le motif de la couche semi-conductrice (4).

14. Procédé de fabrication selon la revendication 13, dans lequel une épaisseur de la couche semi-conductrice (4) dans la direction perpendiculaire au substrat de base (1) est de 100 à 300 nm.

15. Procédé de fabrication selon la revendication 13 ou 14, dans lequel une profondeur de la rainure dans la direction perpendiculaire au substrat de base (1) est de 100 à 400 nm.
